# FASCICULE DE BREVET EUROPEEN

(11) **EP 4 305 674 B1**
(45) Date de publication et mention de la délivrance du brevet: **29.01.2025**
(21) Numéro de dépôt: 22710329.8
(22) Date de dépôt: 16.02.2022
(51) Int. Cl.: H01L 31/0747, H01L 31/18, H01L 31/20

(54) **PROCÉDÉ ET SYSTÈME DE TRAITEMENT D'UN EMPILEMENT DESTINÉ À LA FABRICATION D'UNE CELLULE PHOTOVOLTAÏQUE À HÉTÉROJONCTION**
VERFAHREN UND SYSTEM ZUR BEHANDLUNG EINES STAPELS ZUR HERSTELLUNG EINER FOTOVOLTAISCHEN ZELLE MIT HETEROÜBERGANG
METHOD AND SYSTEM FOR TREATING A STACK INTENDED FOR THE MANUFACTURE OF A HETEROJUNCTION PHOTOVOLTAIC CELL

(30) Priorité: 08.03.2021 FR 2102211
(43) Date de publication de la demande: 17.01.2024
(73) Titulaire: Commissariat à l'Energie Atomique et aux Energies Alternatives, 75015 Paris (FR)
(72) Inventeur: JERONIMO, Pedro, 38054 Grenoble Cedex 09 (FR)
(74) Mandataire: INNOV-GROUP
(86) Numéro de dépôt international: PCT/EP2022/053843
(87) Numéro de publication internationale: WO 2022/189110

(56) Documents cités:
- WO-A1-2013/001440
- WO-A1-2020/082131
- FR-A1- 3 099 294
- MADUMELU CHUKWUKA ET AL: "Investigation of light-induced degradation in N-Type silicon heterojunction solar cells during illuminated annealing at elevated temperatures", SOLAR ENERGY MATERIALS AND SOLAR CELLS, ELSEVIER SCIENCE PUBLISHERS, AMSTERDAM, NL, vol. 218, 1 September 2020 (2020-09-01), XP086293834, ISSN: 0927-0248, [retrieved on 20200901], DOI: 10.1016/J.SOLMAT.2020.110752

## Description

### Domaine technique de l'invention

La présente invention se rapporte à un procédé de traitement d'un empilement destiné à la fabrication d'une cellule photovoltaïque à hétérojonction.

L'invention concerne également le système de traitement correspondant, destiné à mettre en oeuvre ledit procédé.

### Etat de la technique

Les cellules photovoltaïques à hétérojonction de silicium (SHJ) sont connues pour voir leur rendement de conversion énergétique s'améliorer d'environ 0,3 % absolu sous l'action conjuguée de l'éclairement et de la température. Ainsi, il est à présent courant de procéder à un traitement dit de bonification des empilements notamment destinés à former les cellules photovoltaïques SHJ ; afin d'en augmenter leur rendement de conversion.

Le document WO2013/001440 décrit un exemple de procédé de traitement de cellule photovoltaïque SHJ comprenant un substrat en silicium cristallin dopé n. Dans ce procédé de traitement, la cellule photovoltaïque est soumise à un flux lumineux d'irradiance supérieure ou égal à 500 W/m2 pendant une durée d'environ 10 heures, tout en étant chauffée à une température comprise entre 20 °C et 200 °C. Une telle durée de traitement est cependant incompatible avec la cadence des lignes de production actuelles de cellules photovoltaïques.

La demande de brevet FR3099294A1 décrit un procédé de traitement d'un empilement dit précurseur de cellule photovoltaïque à hétérojonction. Ce procédé est mis en oeuvre en fin de fabrication et consiste principalement à exposer ledit empilement à un rayonnement électromagnétique intense (supérieur à 200kW/m²) pendant une durée relativement courte (une dizaine de secondes). Grâce à cette exposition temporaire et intense au rayonnement, on a constaté une bonification de la cellule obtenue et une augmentation de son rendement en fonctionnement.

Exposé au rayonnement électromagnétique, la température de l'empilement augmente fortement et peut atteindre une valeur supérieure à 200°C, pouvant aller jusqu'à 240°C. Afin de limiter la température de l'empilement à une valeur située en dessous de 200°C et d'éviter la détérioration de la cellule obtenue, il est nécessaire de prévoir une solution de refroidissement. La demande de brevet FR3099294A1 précitée évoque la nécessité d'un refroidissement, sans proposer d'éléments concrets pour le mettre en oeuvre.

La publication référencée *"*MADUMELU CHUKWUKA ET AL : "Investigation of light induced dégradation in N-type silicon heterojunction solar cells during illuminated annealing at elevated temperatures" - Solar Energy Materials and solar cells elsevier science publishers, Amsterdam NL - vol. 218, 1 septembre 2020 - XP086293834*"* concerne une étude sur la dégradation des cellules PV à hétérojonction lorsqu'elles sont soumises à une haute température.

Le but de l'invention est donc de proposer un procédé de traitement d'un empilement précurseur de cellule photovoltaïque, qui permet de maintenir l'intégrité de l'empilement, lors de son exposition au rayonnement électromagnétique.

Le procédé permet notamment de traiter des cellules photovoltaïques en continu, avec une cadence élevée, permettant ainsi une industrialisation du procédé.

### Exposé de l'invention

Ce but est atteint par un procédé de traitement d'un empilement qui comporte au moins :
- Un substrat en silicium cristallin,
- Une première couche de passivation en silicium amorphe hydrogéné, disposée sur une première face du substrat,
- Une première couche en silicium amorphe dopée selon un premier type de conductivité, disposée sur la première couche de passivation,

Ledit procédé comprenant des étapes de :
- Placement dudit empilement dans un boîtier,
- Exposition dudit empilement à un rayonnement électromagnétique,
- Mesure de la température de l'empilement,
- Mesure de la température ambiante présente dans ledit boîtier,
- Refroidissement dudit empilement en cours d'exposition,

Ledit procédé étant caractérisé en ce que le refroidissement dudit empilement est mis en oeuvre par :
- Injection d'un flux de gaz dans ledit boîtier,
- Régulation du flux de gaz injecté en tenant compte de la température de l'empilement mesurée,
- Evacuation du flux de gaz en dehors du boîtier en tenant compte de la température ambiante mesurée dans ledit boîtier.

Selon une particularité, l'étape de régulation comporte des étapes de :
- Mesure de la température de l'empilement,
- Comparaison de la température mesurée avec une première valeur de consigne,
- Commande d'une vanne d'injection du flux de gaz dans le boîtier en fonction de la différence entre la température mesurée et ladite valeur de consigne.

Selon une autre particularité, l'étape d'évacuation du flux de gaz comporte des étapes de :
- Mesure de la température ambiante présente dans ledit boîtier,
- Comparaison de la température ambiante mesurée avec une deuxième valeur de consigne,
- Commande de moyens d'évacuation du flux de gaz en dehors du boîtier en fonction de la différence entre la température ambiante mesurée et ladite deuxième valeur de consigne.

Un autre but de l'invention est de proposer un système de traitement permettant de remplir également cet objectif.

Ce but est atteint par un système de traitement d'un empilement destiné à la fabrication d'une cellule photovoltaïque, ledit empilement comprenant au moins :
- Un substrat en silicium cristallin,
- Une première couche de passivation en silicium amorphe hydrogéné, disposée sur une première face du substrat,
- Une première couche en silicium amorphe dopée selon un premier type de conductivité, disposée sur la première couche de passivation,

Ledit système comprenant :
- Un boîtier destiné à recevoir ledit empilement,
- Une source configurée pour émettre un rayonnement électromagnétique à destination dudit empilement,

Ledit système comportant :
- Des premiers moyens de mesure de la température de l'empilement, Ledit système étant caractérisé en ce qu'il comporte :
- Des deuxièmes moyens de mesure de la température ambiante à l'intérieur du boîtier,
- Des moyens d'injection d'un flux de gaz à l'intérieur du boîtier via une entrée principale,
- Des premiers moyens de commande desdits moyens d'injection du flux de gaz, tenant compte de la température mesurée de l'empilement,
- Des moyens d'évacuation du flux de gaz en dehors du boîtier,
- Des deuxièmes moyens de commande des moyens d'évacuation, tenant compte de la température ambiante mesurée à l'intérieur du boîtier.

Selon une particularité, les moyens d'émission de rayonnement électromagnétique comportent des diodes électroluminescentes.

Selon une autre particularité, les moyens d'injection du flux de gaz comportent au moins une vanne commandable par lesdits premiers moyens de commande, agencée sur ladite entrée principale de gaz.

Selon une autre particularité, les moyens d'injection comportent une pluralité d'ouvertures ménagées à travers une paroi dudit boîtier et reliées à ladite entrée principale de gaz.

Selon une autre particularité, les moyens d'injection comportent un canal de distribution du gaz agencé entre ladite entrée principale et lesdites ouvertures.

Selon une autre particularité, ledit canal de distribution est de type planaire en spirale.

Selon une autre particularité, le système comporte des moyens de refroidissement de ladite source de rayonnement électromagnétique et/ou du flux de gaz injecté dans ledit boîtier. Ces moyens de refroidissement peuvent comporter un serpentin dans lequel circule un fluide caloporteur.

Selon une autre particularité, les moyens d'évacuation du flux de gaz comportent un ou plusieurs ventilateurs agencés dans une paroi du boîtier.

Selon une autre particularité, le système comporte des premiers moyens de mesure de la température de l'empilement.

Selon une autre particularité, les premiers moyens de commande sont configurés pour exécuter une première boucle de régulation en température, à partir de la température mesurée par les premiers moyens de mesure et d'une première valeur de consigne.

Selon une autre particularité, le système comporte des deuxièmes moyens de mesure de la température ambiante à l'intérieur du boîtier.

Selon une autre particularité, les deuxièmes moyens de commande sont configurés pour exécuter une deuxième boucle de régulation en température, à partir de la température mesurée par les deuxièmes moyens de mesure et d'une deuxième valeur de consigne.

### Brève description des figures

D'autres caractéristiques et avantages vont apparaître dans la description détaillée qui suit faite en regard des dessins annexés dans lesquels :
- La figure 1 représente de manière schématique le système de traitement de l'invention ;
- La figure 2 représente, par une vue en perspective, le système de l'invention ;
- La figure 3 représente de manière schématique l'architecture du système de l'invention et illustre son principe de fonctionnement ;
- La figure 4 illustre, par une vue en éclaté, l'architecture du système de l'invention et illustre son principe de fonctionnement ;
- La figure 5 illustre le principe de fonctionnement des moyens d'évacuation du flux de gaz ;
- La figure 6 représente un diagramme illustrant le principe de refroidissement employé dans le système de l'invention ;
- La figure 7 montre un diagramme représentant un exemple de boucle de régulation en température exécutée pour commander les moyens d'injection de gaz ;
- La figure 8 montre un diagramme représentant un exemple de boucle de régulation en température exécutée pour commander les moyens d'évacuation du flux de gaz ;

### Description détaillée d'au moins un mode de réalisation

Dans la suite de la description, les termes "supérieur", "inférieur", "au-dessus", "au-dessous" ou équivalents sont à prendre en compte en tenant compte d'une direction verticale tracée dans le plan de la feuille et dite direction principale (A).

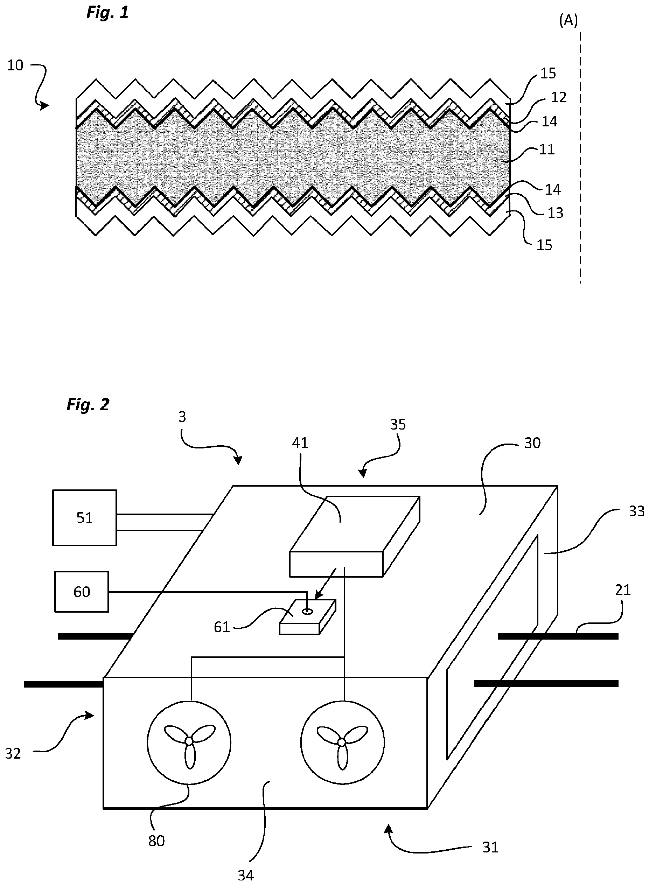

Le procédé de l'invention s'applique à un empilement de couches, servant à fabriquer une cellule photovoltaïque à hétérojonction. Un tel empilement est en général appelé "précurseur de cellule photovoltaïque". De manière non limitative, comme décrit dans la demande de brevet FR3099294A1 et représenté sur la figure 1, l'empilement 10 peut présenter l'architecture suivante :
- Un substrat 11 en silicium cristallin, par exemple dopé n ;
- Une première couche de passivation 14 en silicium amorphe hydrogéné (et de préférence intrinsèque) disposée sur la première face du substrat 11 ;
- Une première couche de silicium amorphe 12, disposée sur la première couche de passivation 14 et dopée d'un premier type de conductivité ;
- Une première couche d'oxyde transparent conducteur 15 disposée sur la première couche dopée de silicium amorphe 12 ;
- Une deuxième couche de passivation 14 en silicium amorphe hydrogéné (et de préférence intrinsèque) disposée sur la deuxième face du substrat 11 ;
- Une deuxième couche de silicium amorphe 13, disposée sur la deuxième couche de passivation 14 et dopée d'un deuxième type de conductivité opposé au premier type de conductivité ; et
- Une deuxième couche d'oxyde transparent conducteur 15 disposée sur la deuxième couche dopée de silicium amorphe 13.

Un tel empilement est qualifié d'asymétrique, car doté de deux couches de silicium amorphe 12, 13 dopées de types de conductvité opposés, de part et d'autre du substrat 11.

Comme indiqué dans la demande de brevet FR3099294A1 précitée, le procédé est un procédé de traitement dit de bonification (également connu sous le nom anglo-saxon de "Light-soaking") qui consiste à exposer un empilement à un traitement thermique sous éclairement ; afin d'améliorer le rendement de la cellule lors de son fonctionnement. Le procédé est en particulier réalisé par exposition à un rayonnement R électromagnétique à l'aide d'une source de rayonnement telle que par exemple des diodes électroluminescentes. Ainsi, l'empilement est exposé au rayonnement R électromagnétique pendant une durée de traitement t qui est fonction de l'irradiance totale E du rayonnement émis et de sa longueur d'onde ou de ses longueurs d'onde.

Au moins une face de l'empilement 10 est exposée audit rayonnement R. Bien entendu, il est également possible d'exposer les deux faces de l'empilement, soit l'une après l'autre ou les deux faces en même temps. Dans ce dernier cas, une deuxième source de rayonnement serait employée, pour éclairer la deuxième face.

De manière non limitative, la face exposée peut être irradiée avec un rayonnement R présentant une irradiance E inférieure ou égale à 200kW/m2 et de préférence entre 25 et 100kW/m2 et par exemple de l'ordre de 50kW/m2. La durée du traitement est avantageusement comprise entre 1s et 30s. La température du traitement est en particulier comprise entre 100 et 250°C, de préférence de l'ordre de 200°C.

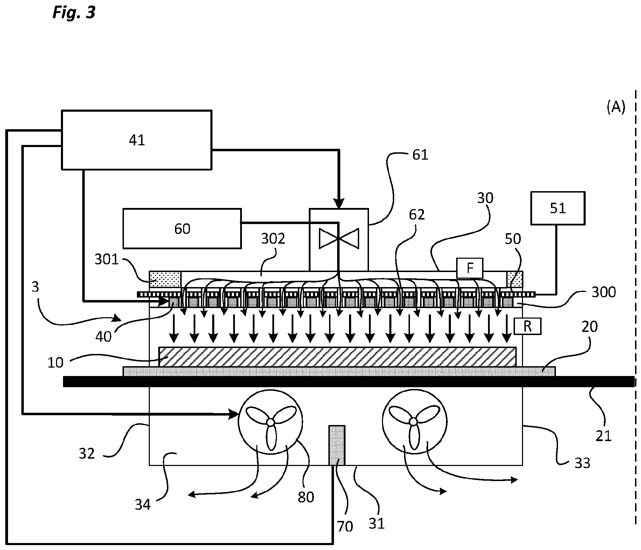

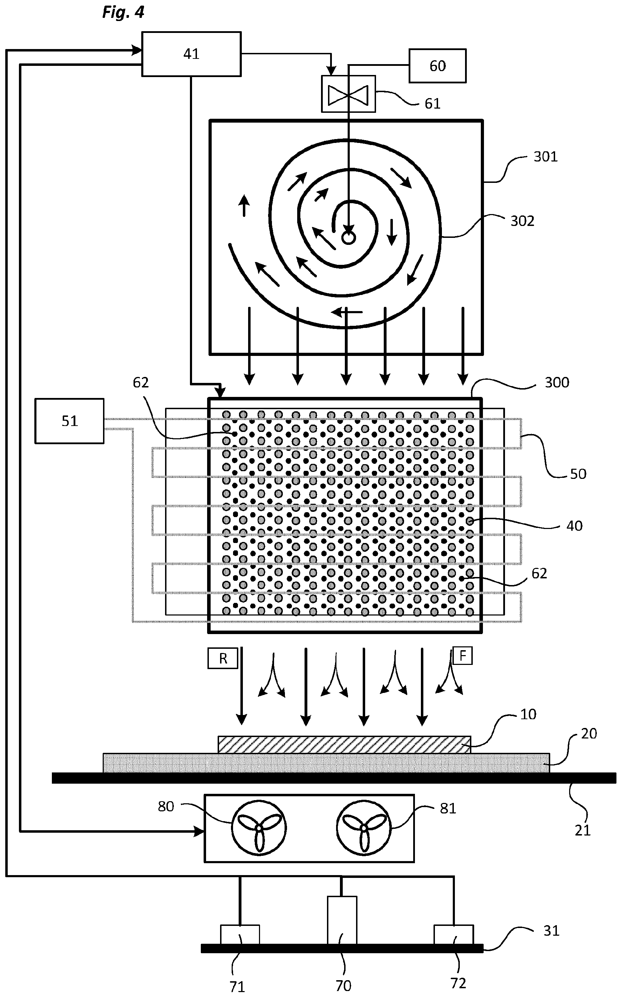

Sur les figures 3 et 4 l'empilement 10 est représenté sous la forme d'un parallélépipède rectangle.

Le système de traitement pour la bonification de l'empilement 10 est décrit en liaison avec la figure 2, la figure 3 et la figure 4.

Le système de traitement peut comporter un support sur lequel est disposé l'empilement 10 à irradier. Ce support 20 peut être disposé sur un système de convoyage comportant une ou plusieurs bandes 21 de convoyage, destinées à traverser le système de traitement de l'invention.

Le système de traitement de l'invention comporte un boîtier 3, par exemple de forme parallélépipédique. Ce boîtier 3 est réalisé dans un matériau résistant à la température, par exemple dans un matériau métallique, par exemple en acier, aluminium ou inox.

Le boîtier 3 comporte ainsi une paroi dite supérieure 30, une paroi dite inférieure 31 et quatre parois latérales opposées deux à deux et dites premières parois latérales 32, 33 et deuxièmes paroi latérales 34, 35. Le boîtier 3 est ouvert sur deux des parois latérales opposées, par exemple les premières parois latérales 32, 33, de manière à être traversé de part en part par les deux bandes 21 de convoyages du support 20. Lorsque l'empilement 10 traverse le boîtier 3, celui-ci est agencé dans un plan parallèle à la paroi supérieure 30 du boîtier 3.

Le système comporte un premier bloc d'émission du rayonnement. Ce premier bloc est par exemple intégré dans la paroi supérieure 30 du boîtier 3. Il comporte la source de rayonnement, composée par exemple d'une ou plusieurs diodes électroluminescentes 40, et un ensemble de commande et d'alimentation électrique 41 destiné à alimenter et commander ladite source de rayonnement. En variante, la source peut également comporter une ou plusieurs lampes de type halogènes, xénon. La source peut également être composée de plusieurs composants de nature distincte, choisis par exemple parmi les diodes électroluminescentes, lampes halogènes, lampes au xénon.

De manière non limitative, les diodes électroluminescentes 40 peuvent être alignées suivant plusieurs rangées et intégrées dans un premier panneau 300 formant en partie la paroi supérieure 30 du boîtier 3. Les diodes électroluminescentes 40 sont orientées pour émettre leur signal lumineux vers l'intérieur du boîtier 3, sensiblement suivant une direction perpendiculaire au plan formé par l'empilement 10 à irradier. Chaque rangée de diodes électroluminescentes 40 peut être réalisée sous la forme d'une bande de plusieurs diodes électroluminescentes connectées en série. Les bandes de diodes électroluminescentes peuvent être connectés en parallèle sur l'ensemble de commande et d'alimentation électrique 41 ou alimentées et commandées chacune de manière indépendante à travers une voie distincte de l'ensemble de commande et d'alimentation électrique 41.

Comme indiqué ci-dessus, le rayonnement R émis par les diodes électroluminescentes 40 à destination de l'empilement 10 entraîne une forte augmentation de la température au niveau de l'empilement, ainsi qu'à l'intérieur du boîtier 3.

Le système comporte ainsi un bloc de refroidissement, agencé et configuré pour maintenir la température de l'empilement 10 au-dessous d'une valeur seuil et ainsi éviter sa potentielle dégradation. Le bloc de refroidissement peut être activé pendant la phase d'exposition au rayonnement et éventuellement après cette phase d'exposition pour faire baisser la température jusqu'à des valeurs acceptables.

Le bloc de refroidissement comporte les éléments principaux suivants :
- Des moyens d'injection d'un flux de gaz F à l'intérieur du boîtier 3,
- Des premiers moyens de commande desdits moyens d'injection du flux de gaz F,
- Des moyens d'évacuation du flux de gaz F en dehors du boîtier,
- Des deuxièmes moyens de commande de ces moyens d'évacuation.

Le flux de gaz F est avantageusement injecté à une température suffisante pour abaisser la température de l'empilement 10 et ainsi éviter sa dégradation. Des moyens de refroidissement du gaz peuvent être éventuellement ajoutés. Le gaz peut être injecté à une température comprise entre 5°C et 25°C.

Les premiers moyens de commande et les deuxièmes moyens de commande peuvent être intégrés à l'ensemble de commande et d'alimentation électrique 41.

Les moyens d'injection peuvent comporter une réserve de gaz 60, le gaz pouvant être par exemple de l'air (par exemple sous forme comprimée), du diazote ou de l'hélium. La réserve de gaz est raccordée sur une entrée principale ménagée sur le boîtier 3, agencée par exemple sur sa paroi supérieure 30. Les moyens d'injection comportent avantageusement au moins une vanne 61 commandable pour ajuster le débit de gaz injecté à l'intérieur du boîtier 3, via ladite entrée principale. Le principe de commande de la vanne 61 est explicité ci-après. A titre d'exemple, le gaz peut être injecté avec un débit compris entre 0.5L et 10L par seconde.

Les moyens d'injection peuvent comporter une pluralité d'ouvertures 62 réalisées à travers le premier panneau 300 de la paroi supérieure du boîtier et débouchant chacune à l'intérieur du boîtier. Ces ouvertures peuvent être réalisées sous forme de plusieurs rangées. Chaque rangée d'ouvertures 62 peut être insérée entre deux rangées de diodes électroluminescentes 40 (figure 4). Chaque ouverture 62 comporte une entrée reliée à l'entrée principale de gaz et une sortie débouchant à l'intérieur du boîtier 3.

De manière avantageuse, le boîtier 3 peut comporter un deuxième panneau 301 fixé au premier panneau 300, au-dessus du premier panneau, formant avec ledit premier panneau la paroi supérieure 30 du boîtier 3. Ce deuxième panneau 301 a pour fonction d'assurer la répartition du gaz au niveau des différentes ouvertures. Ce deuxième panneau peut ainsi intégrer un canal 302 planaire en spirale. Le canal 302 est ajouté en aval de l'entrée principale de gaz. Lorsque le flux de gaz F est injecté, celui-ci suit la forme en spirale du canal 302. Le premier panneau 300 est fixé sous le deuxième panneau 301 de sorte que l'entrée de chaque ouverture 62 réalisée à travers le premier panneau 300 communique avec le canal. En circulant dans le canal 302, le gaz vient ainsi se répartir de manière uniforme à travers les ouvertures 62 et se diffuser à l'intérieur du boîtier 3.

De manière avantageuse, le système peut comporter des moyens de refroidissement, agencés et configurés pour refroidir la source de rayonnement et/ou le gaz injecté. Ces moyens de refroidissement peuvent comporter un serpentin 50 dans lequel circule un fluide caloporteur et un système de pompage 51 externe destiné à assurer la circulation du fluide caloporteur dans le serpentin 50. Ce serpentin 50 peut être intégré dans le premier panneau 300 de la paroi supérieure 30 du boîtier et être agencé au-dessus de l'ensemble de l'ensemble des diodes électroluminescentes 40 pour assurer une dissipation thermique au niveau de la source de rayonnement. Les moyens de refroidissement peuvent également être employés pour refroidir le gaz injecté à l'intérieur du boîtier 3. Les ouvertures 62 peuvent ainsi être agencés pour traverser le serpentin 50, permettant ainsi de refroidir le gaz au contact du serpentin.

Les premiers moyens de commande des moyens d'injection sont configurés pour gérer le débit de gaz injecté à l'intérieur du boîtier 3, en tenant compte de la température mesurée au niveau de l'empilement 10.

Le système comporte ainsi des moyens de mesure de la température au niveau de l'empilement 10 à irradier. Ces moyens de mesure peuvent comporter un capteur 70 de type pyromètre agencé sous l'empilement 10 et par exemple fixé sur la face supérieure de la paroi inférieure 31 du boîtier 3. Ce capteur 70 est destiné à recueillir la température au niveau de l'empilement 10 et non la température ambiante présente à l'intérieur du boîtier 3.

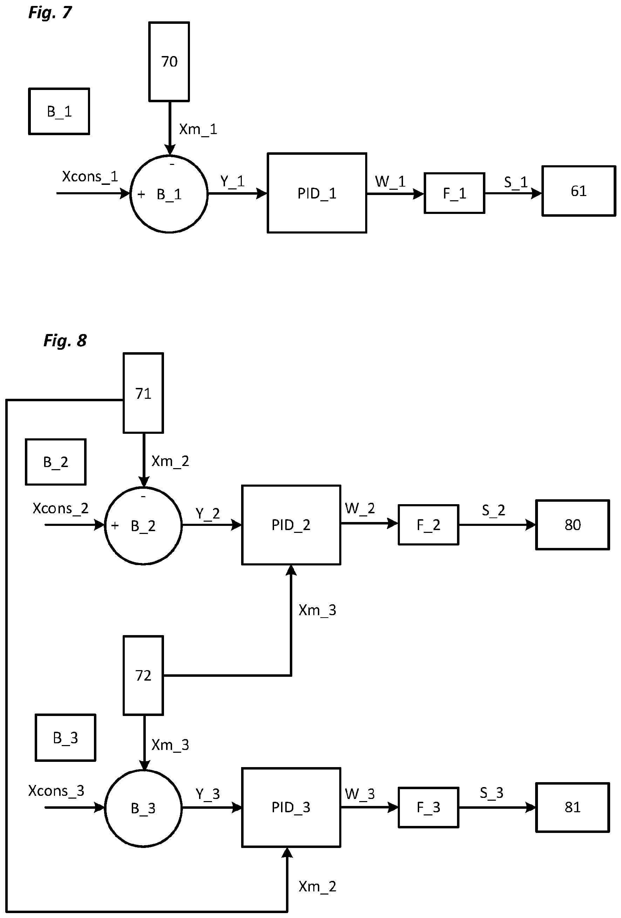

En référence à la figure 7, les premiers moyens de commande sont configurés pour exécuter une première boucle de régulation en température en vue d'appliquer une commande adaptée de la vanne et d'ajuster le débit de gaz injecté à la température de l'empilement 10.

A titre d'exemple, cette première boucle de régulation B_1 peut présenter la structure suivante :
- Un bloc de comparaison C_1 reçoit en entrée une valeur de consigne Xcons_1 de température et une valeur de température mesurée Xm_1 au niveau de l'empilement 10 (par le pyromètre) ; La valeur de consigne Xcons_1 correspond à la température que l'on souhaite obtenir. Elle peut être d'environ 200°C, par exemple comprise entre 180°C et 250°C.
- Le premier bloc de comparaison B_1 est configuré pour déterminer la différence Y_1 entre les deux valeurs de température reçues en entrée ;
- La différence Y_1 entre les deux valeurs de température est injectée dans un correcteur PID_1 (Proportionnel - Intégral - Dérivé) destiné à déterminer une commande W_1 en sortie, représentative de la différence de température reçue en entrée ;
- La fonction de transfert F_1 du procédé détermine le signal de commande S_1 à appliquer à la vanne 61 commandable pour réguler la température mesurée à la valeur de consigne ;

En fonction de la température mesurée au niveau de l'empilement 10 et de sa variation par rapport à la valeur de consigne, le débit de gaz injecté à l'intérieur du boîtier 3 sera ainsi augmenté, maintenu constant ou diminué.

Le bloc de refroidissement comporte également des moyens d'évacuation du flux de gaz F injecté dans le boîtier 3, afin d'extraire les calories produites lors du refroidissement. Ces moyens d'évacuation peuvent comporter un ou plusieurs ventilateurs 80, 81.

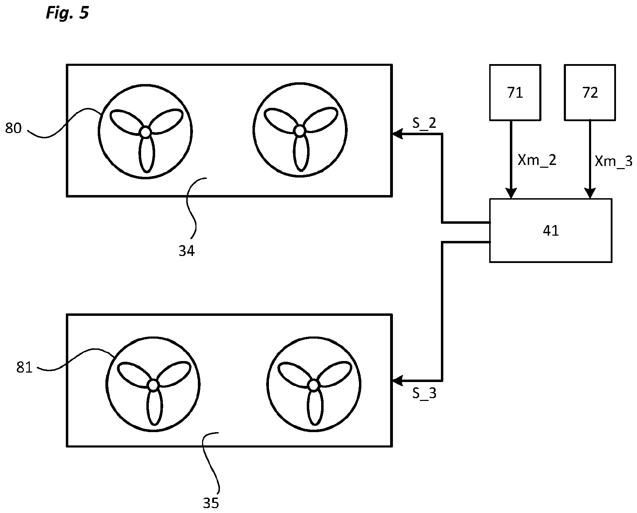

De manière non limitative, comme représenté sur la figure 5, les moyens d'évacuation sont réalisés sous la forme de plusieurs ventilateurs. Les ventilateurs sont par exemple intégrés aux deux deuxièmes parois latérales 34, 35 du boîtier 3.

Les ventilateurs 80, 81 sont avantageusement tous identiques. De manière non limitative, ils peuvent être commandés de manière distincte, par groupe. On peut ainsi distinguer un premier groupe comprenant un ou plusieurs ventilateurs 80 intégrés à une première paroi 34 latérale des deuxièmes parois latérales et un deuxième groupe comprenant un ou plusieurs ventilateurs 81 intégrés à la paroi 35 latérale opposée.

A titre d'exemple, les moyens d'évacuation peuvent comporter au total quatre ventilateurs, deux ventilateurs par groupe.

Dans chaque groupe de plusieurs ventilateurs, les ventilateurs 80, 81 sont commandés de manière identique pour tourner à la même vitesse.

Les deuxièmes moyens de commande sont configurés pour exécuter, pour chaque groupe de ventilateurs, une boucle de régulation en température, en tenant compte de la température ambiante mesurée à l'intérieur du boîtier 3.

Le système comporte ainsi des moyens de mesure de la température à l'intérieur du boîtier 3. Ils peuvent comporter une ou plusieurs sondes de température 71, 72. De manière avantageuse, le système peut comporter une première sonde 71 dédiée à la régulation du premier groupe de ventilateurs 80 et une deuxième sonde 72 dédiée à la régulation du deuxième groupe de ventilateurs 81.

En référence à la figure 5 et à la figure 8, pour le premier groupe de ventilateurs 80, la boucle de régulation B_2 peut présenter la structure suivante :
- Un bloc de comparaison C_2 reçoit en entrée une valeur de consigne de température Xcons_2 et une valeur de température mesurée Xm_2 à l'intérieur du boîtier 3 par une sonde de température 71 ; La valeur de consigne Xcons_2 correspond à la température que l'on souhaite obtenir. Elle peut être d'environ 200°C, par exemple comprise entre 180°C et 250°C.
- La différence Y_2 entre les deux valeurs de température est injectée dans un correcteur PID_2 (Proportionnel - Intégral - Dérivé) destiné à déterminer une commande W_2 en sortie, représentative de la différence de température reçue en entrée ;
- La fonction de transfert F_2 du procédé détermine le signal de commande S_2 à appliquer aux moyens d'évacuation, c'est-à-dire aux ventilateurs ;

La même boucle de régulation peut être exécutée pour le deuxième groupe de ventilateurs 81. Sur la figure 5 et la figure 8, l'indice _3 est indiqué pour référencer cette boucle B_3.

En fonction de la température mesurée à l'intérieur du boîtier 3 et de sa variation par rapport à la valeur de consigne Xcons_2, Xcons_3, la vitesse de rotation des ventilateurs 80, 81 du groupe sera augmentée, maintenu constante ou diminuée.

Selon une particularité, comme illustré sur la figure 8, la température mesurée par chaque sonde de température 71, 72 dédiée à un groupe de ventilateurs peut être injectée dans la boucle de régulation destinée à la régulation de l'autre groupe de ventilateurs. Chaque correcteur PID_2, PID_3 d'une boucle de régulation reçoit la température mesurée provenant de l'autre boucle de régulation. Les deux boucles de régulation sont ainsi entrelacées. Autrement dit, les deuxièmes moyens de commande peuvent être configurés pour agir sur chaque correcteur PID_2, PID_3 en vue d'ajuster la correction à effectuer. Il peut notamment s'agir de corriger de manière plus importante pour un groupe que pour l'autre, selon les mesures de température obtenues, par exemple pour faire en sorte d'obtenir une température homogène à l'intérieur du boîtier.

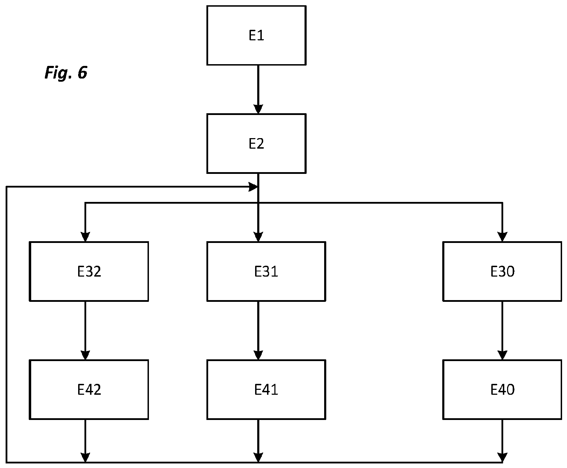

Partant de l'architecture décrite ci-dessus, en liaison avec la figure 6, le procédé de traitement suit les étapes suivantes :
E1 : L'empilement 10 est en position à l'intérieur du boîtier 3, prêt à recevoir le rayonnement R ;
E2 : La source de rayonnement formée des diodes électroluminescentes 40 est activée par l'ensemble de commande et d'alimentation électrique 41 ;
E30, E31, E32 : Après activation du rayonnement R, la température est mesurée respectivement :
   - Par le capteur de température 70 pour mesurer la température de l'empilement 10 (étape E30) ;
   - Par la première sonde de température 71 pour mesurer la température dans le boîtier 3 en vue de la commande du premier groupe de ventilateurs 80 (étape E31) ; et
   - Par la deuxième sonde de température 72 pour mesurer la température dans le boîtier en vue de la commande du deuxième groupe de ventilateurs 81 (étape E32) ;
E40, E41, E42 : En fonction des températures mesurées, les différentes régulations sont mises en oeuvre par :
   - Commande de la vanne 61 pour ajuster le du flux de gaz F injecté dans le boîtier 3 en exécutant la première boucle de régulation B_1 (étape E40) ;
   - Commande du premier groupe de ventilateurs 80 pour évacuer les calories en appliquant la deuxième boucle de régulation B_2 (étape E41) ;
   - Commande du deuxième groupe de ventilateurs 81 pour évacuer les calories en exécutant la troisième boucle de régulation B_3 (étape E42) ;

Ce process est appliqué pendant une durée déterminée, tant que le rayonnement R est émis et éventuellement à l'issue de l'émission pour assurer une baisse suffisante des températures dans le boîtier 3.

Certaines variantes de réalisation sont envisageables :
- Il est possible de prévoir une autre forme que celle en spirale du canal 302 planaire ; Le principe est de conserver une répartition uniforme du gaz à l'intérieur du boîtier 3 ;
- Les moyens d'évacuation du flux de gaz peuvent comporter un ventilateur intégré à la paroi inférieure 31 du boîtier 3, venant s'ajouter aux ventilateurs déjà présents ou les remplacer ;
- Le système peut comporter un dispositif de mesure du courant circulant dans chaque bande de diodes électroluminescentes 40 ; En fonction du courant mesuré, l'ensemble de commande et d'alimentation électrique 41 peut ajuster la commande de chaque bande de diodes électroluminescentes ; Il est également possible de détecter un dysfonctionnement dans une bande de diodes électroluminescentes,
- Le système peut intégrer plusieurs entrées de gaz vers l'intérieur du boîtier 3, une vanne commandable distincte permettant d'ajuster le débit de gaz injecté via chacune de ces entrées ;
- L'ensemble de commande et d'alimentation électrique 41 des diodes électroluminescentes, les premiers moyens de commande et les deuxièmes moyens de commande peuvent être réunis en un seul bloc de commande, fixé au boîtier 3, par exemple sur sa paroi supérieure 30 ;
- Les boucles de régulation peuvent être réalisées selon d'autres variantes ;

L'invention présente de nombreux avantages, parmi lesquels :
- Elle offre une solution concrète de refroidissement lors du traitement par rayonnement d'un empilement ;
- Elle présente une architecture simple, facilement implantable sur une chaîne de production de cellules photovoltaïques ;

## Revendications

1. Procédé de traitement d'un empilement (10) destiné à la fabrication d'une cellule photovoltaïque, ledit empilement comportant au moins :
- Un substrat (11) en silicium cristallin,
- Une première couche de passivation (14) en silicium amorphe hydrogéné, disposée sur une première face du substrat,
- Une première couche en silicium amorphe (12) dopée selon un premier type de conductivité, disposée sur la première couche de passivation (14),
Ledit procédé comprenant des étapes de :
- Placement dudit empilement (10) dans un boîtier (3),
- Exposition dudit empilement (10) à un rayonnement électromagnétique (R),
- Mesure de la température de l'empilement (10),
- Mesure de la température ambiante présente dans ledit boîtier (3),
- Refroidissement dudit empilement (10) en cours d'exposition,
Ledit procédé étant **caractérisé en ce que** le refroidissement dudit empilement est mis en oeuvre par :
- Injection d'un flux de gaz (F) dans ledit boîtier (3),
- Régulation du flux de gaz (F) injecté en tenant compte de la température de l'empilement (10) mesurée,
- Evacuation du flux de gaz (F) en dehors du boîtier (3) en tenant compte de la température ambiante mesurée dans ledit boîtier (3).

2. Procédé selon la revendication 1, **caractérisé en ce que** l'étape de régulation comporte des étapes de :
- Mesure de la température de l'empilement (10),
- Comparaison de la température mesurée avec une première valeur de consigne (Xcons_1),
- Commande d'une vanne (61) d'injection du flux de gaz (F) dans le boîtier (3) en fonction de la différence entre la température mesurée (Xm_1) et ladite valeur de consigne (Xcons_1).

3. Procédé selon la revendication 1 ou 2, **caractérisé en ce que** l'étape d'évacuation du flux de gaz comporte des étapes de :
- Mesure de la température ambiante présente dans ledit boîtier (3),
- Comparaison de la température ambiante mesurée (Xm_2, Xm_3) avec une deuxième valeur de consigne (Xcons_2, Xcons_3),
- Commande de moyens d'évacuation du flux de gaz en dehors du boîtier (3) en fonction de la différence entre la température ambiante mesurée et ladite deuxième valeur de consigne.

4. Système de traitement d'un empilement (10) destiné à la fabrication d'une cellule photovoltaïque, ledit empilement comprenant au moins :
- Un substrat (11) en silicium cristallin,
- Une première couche de passivation (14) en silicium amorphe hydrogéné, disposée sur une première face du substrat,
- Une première couche en silicium amorphe (12) dopée selon un premier type de conductivité, disposée sur la première couche de passivation (14),
Ledit système comprenant :
- Un boîtier (3) destiné à recevoir ledit empilement (3) ;
- Une source configurée pour émettre un rayonnement électromagnétique (R) à destination dudit empilement (10),
- Des premiers moyens de mesure (70) de la température de l'empilement (10),
- Des deuxièmes moyens de mesure (71, 72) de la température ambiante à l'intérieur du boîtier (3),
Ledit système étant **caractérisé en ce qu'**il comporte :
- Des moyens d'injection d'un flux de gaz (F) à l'intérieur du boîtier via une entrée principale,
- Des premiers moyens de commande desdits moyens d'injection du flux de gaz, tenant compte de la température mesurée de l'empilement,
- Des moyens d'évacuation du flux de gaz en dehors du boîtier (3),
- Des deuxièmes moyens de commande des moyens d'évacuation, tenant compte de la température ambiante mesurée à l'intérieur du boîtier.

5. Système selon la revendication 4, **caractérisé en ce que** les moyens d'émission de rayonnement électromagnétique (R) comportent des diodes électroluminescentes (40).

6. Système selon la revendication 4 ou 5, **caractérisé en ce que** les moyens d'injection du flux de gaz comportent au moins une vanne (61) commandable par lesdits premiers moyens de commande, agencée sur ladite entrée principale de gaz.

7. Système selon la revendication 6, **caractérisé en ce que** les moyens d'injection comportent une pluralité d'ouvertures (62) ménagées à travers une paroi dudit boîtier (3) et reliées à ladite entrée principale de gaz.

8. Système selon l'une des revendications 4 à 6, **caractérisé en ce que** les moyens d'injection comportent un canal (302) de distribution du gaz agencé entre ladite entrée principale et lesdites ouvertures (62).

9. Système selon la revendication 8, **caractérisé en ce que** ledit canal (302) de distribution est de type planaire en spirale.

10. Système selon l'une des revendications 4 à 9, **caractérisé en ce qu'**il comporte des moyens de refroidissement de ladite source de rayonnement électromagnétique et/ou du flux de gaz injecté dans ledit boîtier.

11. Système selon l'une des revendications 4 à 10, **caractérisé en ce que** les moyens d'évacuation du flux de gaz comportent un ou plusieurs ventilateurs (80, 81) agencés dans une paroi du boîtier (3).

12. Système selon la revendication 4, **caractérisé en ce que** les premiers moyens de commande sont configurés pour exécuter une première boucle de régulation (B_1) en température, à partir de la température mesurée (Xm_1) par les premiers moyens de mesure et d'une première valeur de consigne (Xcons_1).

13. Système selon la revendication 4, **caractérisé en ce que** les deuxièmes moyens de commande sont configurés pour exécuter une deuxième boucle de régulation (B_2, B_3) en température, à partir de la température mesurée (Xm_2, Xm_3) par les deuxièmes moyens de mesure et d'une deuxième valeur de consigne (Xcons_2, Xcons_3).

## Patentansprüche

1. Verfahren zur Behandlung eines Stapels (10) zur Herstellung einer Photovoltaikzelle, wobei der Stapel mindestens Folgendes aufweist:
- ein Substrat (11) aus kristallinem Silizium,
- eine erste Passivierungsschicht (14) aus hydriertem amorphem Silizium, die auf einer ersten Seite des Substrats angeordnet ist,
- eine erste Schicht aus amorphem Silizium (12), die entsprechend einem ersten Leitfähigkeitstyp dotiert ist und auf der ersten Passivierungsschicht (14) angeordnet ist, wobei das Verfahren die folgende Schritte aufweist:
- Platzieren des Stapels (10) in einem Gehäuse (3),
- Aussetzen des Stapels (10) einer elektromagnetischen Strahlung (R),
- Messen der Temperatur des Stapels (10),
- Messen der im Gehäuse (3) vorhandenen Umgebungstemperatur,
- Kühlen des Stapels (10) während des Aussetzens,
wobei das Verfahren **dadurch gekennzeichnet ist, dass** das Kühlen des Stapels durchgeführt wird durch:
- Einleiten eines Gasstroms (F) in das Gehäuse (3),
- Regeln des eingeleiteten Gasstroms (F) unter Berücksichtigung der gemessenen Temperatur des Stapels (10),
- Ableiten des Gasstroms (F) aus dem Gehäuse (3) unter Berücksichtigung der im Gehäuse (3) gemessenen Umgebungstemperatur.

2. Verfahren nach Anspruch 1, **dadurch gekennzeichnet, dass** der Schritt zum Regeln darüber hinaus die folgenden Schritte aufweist:
- Messen der Temperatur des Stapels (10),
- Vergleichen der gemessenen Temperatur mit einem ersten Sollwert (Xcons_1),
- Steuern eines Ventils (61) zum Einleiten des Gasstroms (F) in das Gehäuse (3) in Abhängigkeit von der Differenz zwischen der gemessenen Temperatur (Xm_1) und dem Sollwert (Xcons_1).

3. Verfahren nach Anspruch 1 oder 2, **dadurch gekennzeichnet, dass** der Schritt zum Ableiten des Gasstroms die folgenden Schritte aufweist:
- Messen der im Gehäuse (3) vorhandenen Umgebungstemperatur,
- Vergleichen der gemessenen Umgebungstemperatur (Xm_2, Xm_3) mit einem zweiten Sollwert (Xcons_2, Xcons_3),
- Steuern von Mitteln zum Ableiten des Gasstroms aus dem Gehäuse (3) in Abhängigkeit von der Differenz zwischen der gemessenen Umgebungstemperatur und dem zweiten Sollwert.

4. System zur Behandlung eines Stapels (10) zur Herstellung einer Photovoltaikzelle, wobei der Stapel mindestens Folgendes aufweist:
- ein Substrat (11) aus kristallinem Silizium,
- eine erste Passivierungsschicht (14) aus hydriertem amorphem Silizium, die auf einer ersten Seite des Substrats angeordnet ist,
- eine erste Schicht aus amorphem Silizium (12), die entsprechend einem ersten Leitfähigkeitstyp dotiert ist und auf der ersten Passivierungsschicht (14) angeordnet ist, wobei das System Folgendes aufweist:
- ein Gehäuse (3) zur Aufnahme des Stapels (3),
- eine Quelle, die so konfiguriert ist, dass sie elektromagnetische Strahlung (R) an den Stapel (10) aussendet,
- erste Mittel (70) zum Messen der Temperatur des Stapels (10),
- zweite Mittel (71, 72) zum Messen der Umgebungstemperatur im Gehäuse (3),
wobei das System **dadurch gekennzeichnet ist, dass** es Folgendes aufweist:
- Mittel zum Einleiten eines Gasstroms (F) in das Innere des Gehäuses über einen Haupteinlass,
- erste Mittel zum Steuern der Mittel zum Einleiten des Gasstroms, die die gemessene Temperatur des Stapels berücksichtigen,
- Mittel zum Ableiten des Gasstroms aus dem Gehäuse (3),
- zweite Mittel zum Steuern der Mittel zum Ableiten unter Berücksichtigung der im Gehäuse gemessenen Umgebungstemperatur.

5. System nach Anspruch 4, **dadurch gekennzeichnet, dass** die Mittel zum Aussenden elektromagnetischer Strahlung (R) Leuchtdioden (40) aufweisen.

6. System nach Anspruch 4 oder 5, **dadurch gekennzeichnet, dass** die Mittel zum Einleiten des Gasstroms mindestens ein Ventil (61) aufweisen, das durch die ersten Mittel zum Steuern gesteuert werden kann und an dem Hauptgaseinlass angeordnet ist.

7. System nach Anspruch 6, **dadurch gekennzeichnet, dass** die Mittel zum Einleiten mehrere Öffnungen (62) aufweisen, die durch eine Wand des Gehäuses (3) hindurch ausgebildet und mit dem Hauptgaseinlass verbunden sind.

8. System nach einem der Ansprüche 4 bis 6, **dadurch gekennzeichnet, dass** die Mittel zum Einleiten einen Gasverteilungskanal (302) aufweisen, der zwischen dem Haupteinlass und den Öffnungen (62) angeordnet ist.

9. System nach Anspruch 8, **dadurch gekennzeichnet, dass** der Verteilungskanal (302) vom Typ spiralförmig planar ist.

10. System nach einem der Ansprüche 4 bis 9, **dadurch gekennzeichnet, dass** es Mittel zum Kühlen der elektromagnetischen Strahlungsquelle und/oder des in das Gehäuse eingeleiteten Gasstroms aufweist.

11. System nach einem der Ansprüche 4 bis 10, **dadurch gekennzeichnet, dass** die Mittel zum Ableiten des Gasstroms einen oder mehrere Ventilatoren (80, 81) aufweisen, die in einer Wand des Gehäuses (3) angeordnet sind.

12. System nach Anspruch 4, **dadurch gekennzeichnet, dass** die ersten Mittel zum Steuern so konfiguriert sind, dass sie aus der von den ersten Mitteln zum Messen gemessenen Temperatur (Xm_1) und einem ersten Sollwert (Xcons_1) eine erste Temperaturregelschleife (B_1) ausführen.

13. System nach Anspruch 4, **dadurch gekennzeichnet, dass** die zweiten Mittel zum Steuern so konfiguriert sind, dass sie aus der von den zweiten Mitteln zum Messen gemessenen Temperatur (Xm_2, Xm_3) und einem zweiten Sollwert (Xcons_2, Xcons_3) eine zweite Temperaturregelschleife (B_2, B_3) ausführen.

## Claims

1. Process for treating a stack (10) intended for manufacture of a photovoltaic cell, said stack comprising at least:
- a crystalline silicon substrate (11),
- a first passivation layer (14) made of hydrogenated amorphous silicon, placed on a first side of the substrate,
- a first layer (12) made of amorphous silicon doped according to a first conductivity type, placed on the first passivation layer (14),
said process comprising steps of:
- placing said stack (10) in an enclosure (3),
- exposing said stack (10) to electromagnetic radiation (R),
- measuring the temperature of the stack (10),
- measuring the ambient temperature present in said enclosure (3),
- cooling said stack (10) during exposure,
said process being **characterized in that** said stack is cooled by:
- injecting a gas flow (F) into said enclosure (3),
- regulating the injected gas flow (F) taking into account the measured temperature of the stack (10),
- evacuating the gas flow (F) from the enclosure (3) taking into account the ambient temperature measured in said enclosure (3).

2. Process according to Claim 1, **characterized in that** the regulating step comprises steps of:
- measuring the temperature of the stack (10),
- comparing the measured temperature with a first setpoint value (Xcons_1),
- controlling an injection valve (61) controlling injection of the gas flow (F) into the enclosure (3) depending on the difference between the measured temperature (Xm_1) and said setpoint value (Xcons_1).

3. Process according to Claim 1 or 2, **characterized in that** the step of evacuating the gas flow comprises steps of:
- measuring the ambient temperature present in said enclosure (3),
- comparing the measured ambient temperature (Xm_2, Xm_3) with a second setpoint value (Xcons_2, Xcons_3),
- controlling means for evacuating the gas flow from the enclosure (3) depending on the difference between the measured ambient temperature and said second setpoint value.

4. System for treating a stack (10) intended for manufacture of a photovoltaic cell, said stack comprising at least:
- a crystalline silicon substrate (11),
- a first passivation layer (14) made of hydrogenated amorphous silicon, placed on a first side of the substrate,
- a first layer (12) made of amorphous silicon doped according to a first conductivity type, placed on the first passivation layer (14),
said system comprising:
- an enclosure (3) intended to receive said stack (3),
- a source configured to emit electromagnetic radiation (R) towards said stack (10),
- first means (70) for measuring the temperature of the stack (10),
- second means (71, 72) for measuring the ambient temperature inside the enclosure (3),
said system being **characterized in that** it comprises:
- means for injecting a gas flow (F) into the enclosure via a main inlet,
- first control means for controlling said means for injecting the gas flow, taking into account the measured temperature of the stack,
- means for evacuating the gas flow from the enclosure (3),
- second control means for controlling the evacuating means, taking into account the ambient temperature measured inside the enclosure.

5. System according to Claim 4, **characterized in that** the means for emitting electromagnetic radiation (R) comprise light-emitting diodes (40).

6. System according to Claim 4 or 5, **characterized in that** the means for injecting the gas flow comprise at least one valve (61) that is controllable by said first control means, said valve being arranged on said main gas inlet.

7. System according to Claim 6, **characterized in that** the injecting means comprise a plurality of apertures (62) that are produced through a wall of said enclosure (3) and that are connected to said main gas inlet.

8. System according to one of Claims 4 to 6, **characterized in that** the injecting means comprise a channel (302) for distributing the gas, arranged between said main inlet and said apertures (62).

9. System according to Claim 8, **characterized in that** said distributing channel (302) is of the planar spiral type.

10. System according to one of Claims 4 to 9, **characterized in that** it comprises means for cooling said source of electromagnetic radiation and/or the gas flow injected into said enclosure.

11. System according to one of Claims 4 to 10, **characterized in that** the means for evacuating the gas flow comprise one or more fans (80, 81) arranged in a wall of the enclosure (3).

12. System according to Claim 4, **characterized in that** the first control means are configured to execute a first temperature-regulating loop (B_1), based on the temperature (Xm_1) measured by the first measuring means and on a first setpoint value (Xcons_1).

13. System according to Claim 4, **characterized in that** the second control means are configured to execute a second temperature-regulating loop (B_2, B_3) based on the temperature (Xm_2, Xm_3) measured by the second measuring means and on a second setpoint value (Xcons_2, Xcons_3).
